# EUROPEAN PATENT SPECIFICATION

(11) **EP 0 405 220 B1**
(45) Date of publication and mention of the grant of the patent: **14.08.1996**
(21) Application number: 90111092.4
(22) Date of filing: 12.06.1990
(51) Int. Cl.: G11C 7/00, G11C 16/06

(54) **Semiconductor memory device**
Halbleiter-Speicher-Einrichtung
Dispositif de mémoire à semi-conducteur

(30) Priority: 12.06.1989 JP 148676/89
(43) Date of publication of application: 02.01.1991
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Iwahashi, Hiroshi, Yokohama-shi, Kanagawa-ken (JP)
(74) Representative: Lehn, Werner, Dipl.-Ing.

(56) References cited:
- EP-A- 0 224 125
- EP-A- 0 270 750
- EP-A- 0 306 990
- GB-A- 2 078 458

## Description

### Background of the Invention

The present invention relates to a semiconductor memory device, as defined in the preamble of claim 1, which is known from EP-A-0 224 125.

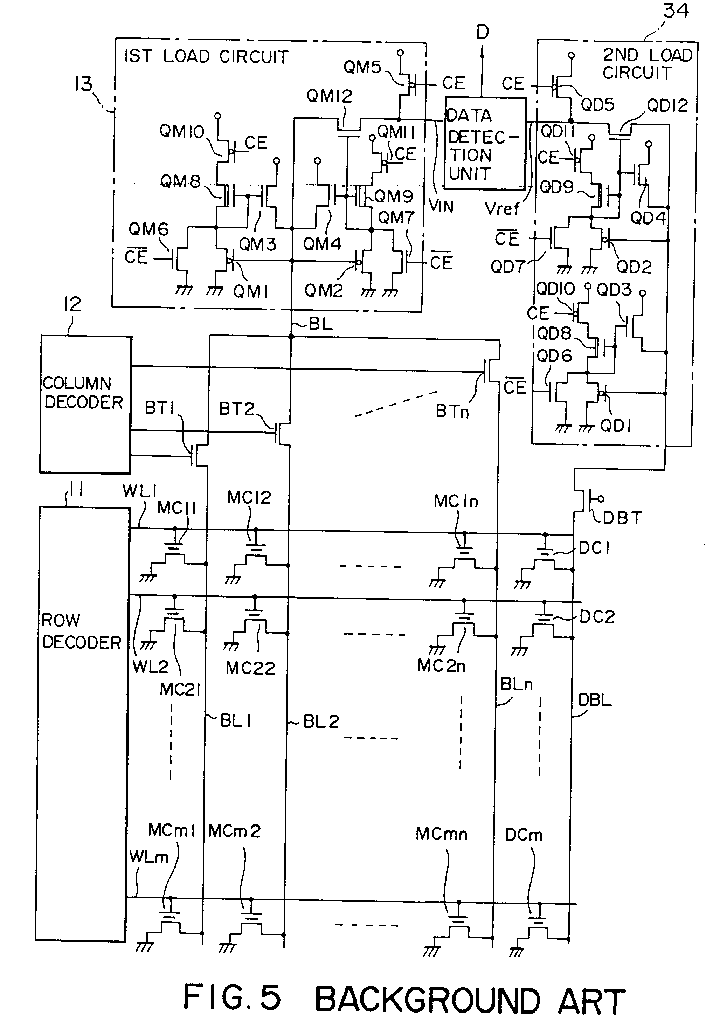

A conventional semiconductor memory device will be described with reference to Fig. 5. This semiconductor memory is an EPROM having memory cells disposed in matrix form. Each of memory cells is a MOSFET having a floating gate and a control gate. Each of memory cells MC11, MC12, ..., Mcmn stores binary data. Each of reference cells DC1, DC2, ..., DCm is a MOSFET having a floating gate, too.

The gates of memory cells and a reference cell at each row are connected to each row or word line WL1, WL2, ..., WLm, the drains of memory cells at each column are connected to each column or bit line BL1, BL2, ..., BLn, and the drain of reference cells are connected to a reference column or reference bit line DBL. Each memory cell is selected by column decoder 12 and row decoder 11. Column gate transistors BT1, BT2, ..., BTn select one of the column lines. The transistor DBT connected to the reference bit line DBL performs an equivalent function to the column gate transistor.

A first load circuit 13 includes MOSFETs QM1 to QM12. The first load circuit 13 amplifies the data from a selected memory cell and outputs it to a data detection circuit 15. A second load circuit 34 includes MOSFETs QD1 to QD12. The second load circuit 34 amplifies the data from a selected reference cell and outputs it to the data detection circuit 15. The data detection circuit 15 compares the data from the selected memory cell with the data from the selected reference cell, and detects the data stored in the selected memory cell and then outputs it to an output buffer. The following is a description of the read operation of the data detection circuit 15 for reading the data stored in a memory cell of the EPROM constructed as above.

Data is programmed in the memory cell by injecting electrons into the floating gate. If the floating gate of a memory cell has injected electrons, it remains off even if a logic "1" level signal is applied to the control gate. If the floating gate of a memory cell is not injected electrons, the memory cell is turned on when a logic "1" level signal is applied to the control gate of the memory cell. Electrons are not injected in the floating gate of a reference cell so that it is electrically equivalent to the memory cell which is not injected electrons.

In the first load circuit 13, the data stored in a selected memory cell is amplified and output as a potential V_{IN}. Similarly, in the second load circuit 34, the data of a selected reference cell is amplified and output as a reference potential V_{REF}. These potentials V_{IN} and V_{REF} are supplied to the data detection circuit 15 which compares them with each other to thereby detect and output the data stored in the memory cell.

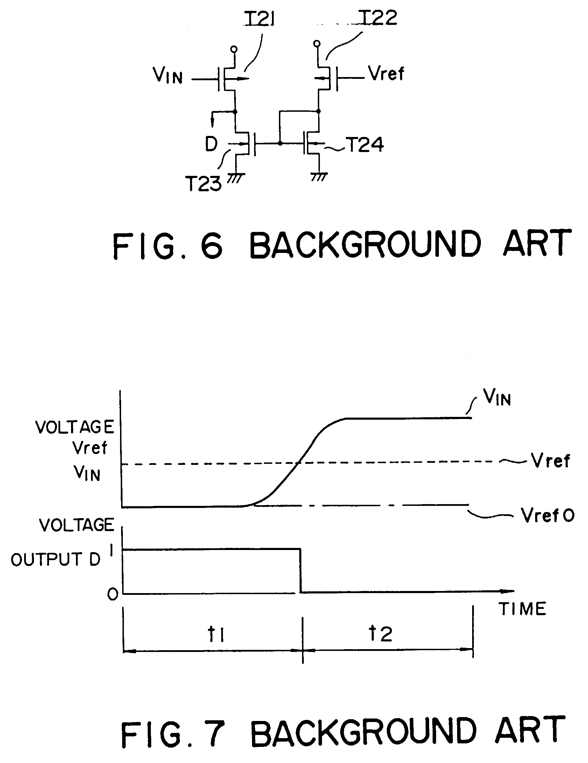

As shown in Fig. 6, the data detection circuit 15 is constructed, for example, as of a difference sense amplifier having p-channel MOSFETs T21 and T22 and n-channel MOSFETs T23 and T24. The reference potential V_{REF} is applied to the gate of the MOSFET T22, and the potential V_{IN} is applied to the gate of MOSFET T21. As shown in Fig. 7, if a selected memory cell is not injected electrons (indicated at time duration t1), the memory cell is turned on and the potential V_{IN} lowers. On the other hand, if a selected memory cell is injected electrons (indicated at time duration t2), the memory cell is turned off and the potential V_{IN} is charged by the load transistor QM5 and the potential V_{IN} becomes high.

If the first and second load circuits 13 and 34 are constructed of the same circuit, the reference potential V_{REF} is the same potential as that when a selected memory cell is not injected electrons (indicated at time duration t1), as shown by a one-dot chain line. Such a reference potential V_{REF} cannot be used as a reference potential for detecting the data stored the memory cell. In order to get a potential difference between the reference potential V_{REF} and the potential V_{IN} for the memory cell which is not injected electrons, the reference potential V_{REF} is set substantially at the middle value between the potential V_{IN} for the memory cell which is injected electrons and the potential V_{IN} for the memory cell which is not injected electrons, as shown by a broken line.

If different voltages are applied to the gates of the reference cell and the memory cell, we get the potential difference between the reference potential V_{REF} and the potential V_{IN} with the first and second load circuits 13 and 34 constructed of the same circuit. In this case, since the gates of the memory cell and reference cell are connected to different signal lines the influence of power source noise on the memory cell is different from the influence of power source noise on the reference cell. Consequently, erroneous operation occurs, when much power source noise is generated. However, the gates of the memory cell and the reference cell are connected to the same row lines WL1 to WLm in order to undergo the same influence of power source noise and to suppress erroneous operation caused by the power source noise. Therefore, the potential difference is obtained by using the different size transistors as the load transistors QM5 and QD5 of the first and second load circuits 13 and 34, respectively. Namely, the channel width of the transistor QD5 is wider than that of the transistor QM5 to raise the reference potential V_{REF} to the broken line level.

With the above arrangement, since there is a difference in the current supply capability between transistors QM5 and QD5, the column line (BL1, BL2, *...,* BLn) and the reference column line (DBL) are influenced differently by power source noise. There still remains the problem that erroneous operation due to power source noise cannot be eliminated entirely.

### SUMMARY OF THE INVENTION

It is therefore an object of the present invention to provide a semiconductor memory device free from erroneous operation caused by power voltage fluctuation.

According to the present invention, there is provided a semiconductor memory device of the initially defined type having the characterizing features of claim 1.

Preferred embodiments are listed in the dependent claims.

According to the present invention, two reference column lines representative of two data states are provided so that there is no need to use the different size load transistors.

One of the two data states is equivalent to that of the column line having a selected memory cell in which electrons are not injected, and the first and second load circuit have the same circuit arrangement electrically equivalent (having the same load resistance). Accordingly, the output from the first load circuit connected to the selected memory cell is the same as the output from the second load circuit connected to a first reference cell. Similarly, another one of the two data states is equivalent to that of the column line having a selected memory cell in which electrons are injected, and the first and third load circuit have the same circuit arrangement electrically equivalent (having the same load resistance). Accordingly, the output from the first load circuit connected to the selected memory cell in which electrons are injected is the same as the output from the third load circuit connected to a second reference cell. The data detection circuit compares the output from the first load circuit with the outputs from the second and third load circuits to detect the data stored the selected memory cell. The first load circuit for memory cells and the second and third load circuits for reference cells have the same circuit arrangement. Accordingly, even if a power source voltage fluctuation (power source noise) occurs, the influence thereof is the same for the outputs of the three load circuits. The power source noise can thus be cancelled during the comparison operation at the data detection circuit, thereby avoiding erroneous operation.

### BRIEF DESCRIPTION OF THE DRAWINGS

Fig. 1 is a circuit diagram showing the semiconductor memory device according to a first embodiment of this invention;
Fig. 1A is a circuit diagram showing the semiconductor memory device according to another embodiment;
Fig. 2 is a circuit diagram showing the data detection circuit of the device shown in Fig. 1;
Fig. 3 is a timing chart illustrating the relationship between the output potentials of the load circuits and the output signal of the data detection circuit shown in Fig. 1;
Fig. 4 is a circuit diagram showing the data detection circuit according to further embodiment;
Fig. 5 is a circuit diagram showing a conventional semiconductor memory device;
Fig. 6 is a circuit diagram showing the data detection circuit shown in Fig. 5;
Fig. 7 is a timing chart illustrating the relationship between the output potentials of the load circuits and the output signal of the data detection unit.

### DESCRIPTION OF THE PREFERRED EMBODIMENTS

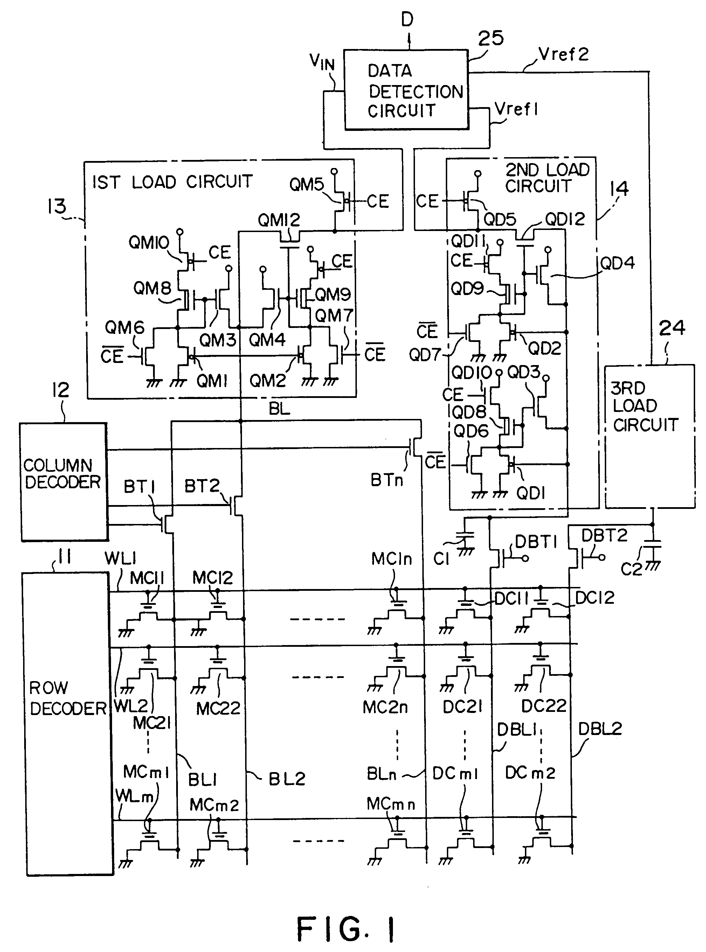

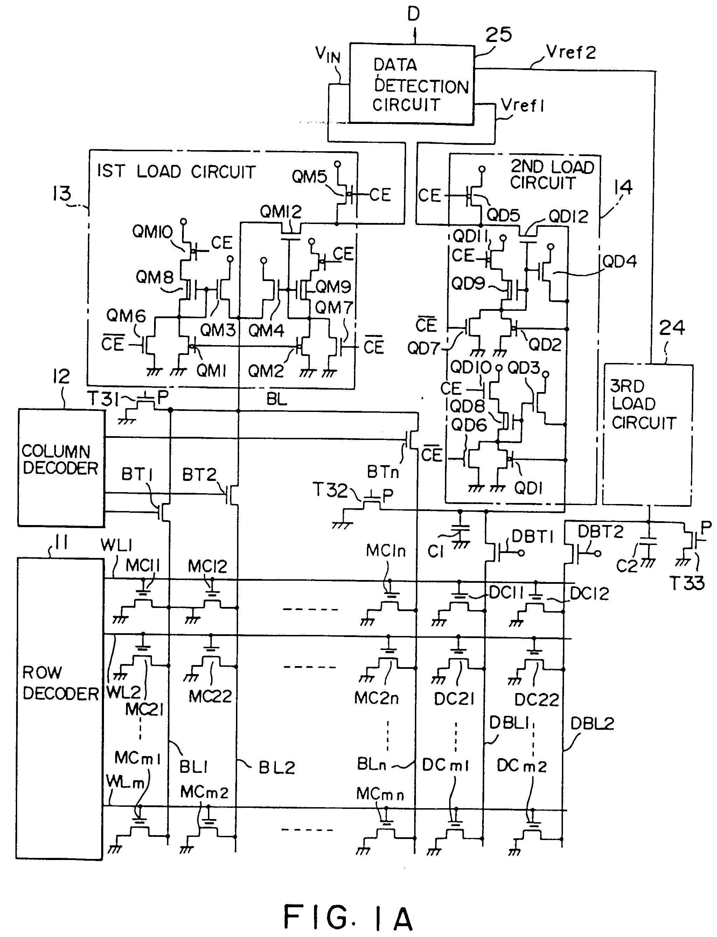

Fig. 1 is a circuit diagram showing the circuit arrangement of the semiconductor memory device according to the embodiment of this invention. Unlike a conventional semiconductor memory cell having a single reference column as shown in Fig. 5, the semiconductor memory cell of this invention has two reference columns, one of the reference columns including reference cells DC11, ..., DCm1 and the other reference column including reference cells DC12, ..., DCm2. The reference columns are connected to second and third load circuits 14 and 24, respectively. A data detection circuit 25 receives potentials V_{IN}, V_{REF1} and V_{REF2} which are output from load circuits 13, 14 and 24 respectively. Like elements to those shown in Fig. 5 are represented by identical reference numerals and symbols, and the description thereof is omitted. Similar to the circuit shown in Fig. 5, n-channel MOSFETs are used. However, it is not limited thereto, but it is obvious that other CMOS circuits including also p-channel MOSFETs may be used depending upon the circuit requirements such as power consumption, operation speed and the like.

The floating gates of reference cells DC11, DC21, ..., DCm1 have no electrons injected, and are equivalent to memory cells which are not injected with electrons. The sources of the reference cells DC12, DC22, ..., DCm2 are not connected to ground so that no current path is established upon selection thereof, and are equivalent to memory cells in which electrons are injected into the floating gates.

The drains of reference cells DC11, DC21, ..., DCm1 are connected to a reference column line DBL1, and the drains of reference cells DC12, DC22, ..., DCm2 to a reference column line DBL2.

The second and third load circuits 14 and 24 connected to the reference column lines DBL1 and DBL2 have the same construction as the first load circuit 13 connected to the column line BL. Each of the second and third load circuits 14 and 24 is constructed of MOSFETs QD1 to QD12. The potential at the reference column line DBL1 is the same as that at a column line having a selected memory cell in which electrons are not injected . The potential at the reference column line DBL2 is the same as that at a column line having a selected memory cell in which electrons are injected.

Unlike a conventional circuit, the load resistances of load transistors QD5 of the second and third load circuits 14 and 24 are the same as that of load transistor QM5 of the load circuit 13.

Capacitors C1 and C2 connected to reference column lines DBL1 and DBL2 are used for compensating parasitic capacitances present at the column gates BT1, BT2, ..., BTn of memory cells. The column line BL and the column line DBL1 and DBL2 constructed as above have equivalent electrical characteristics.

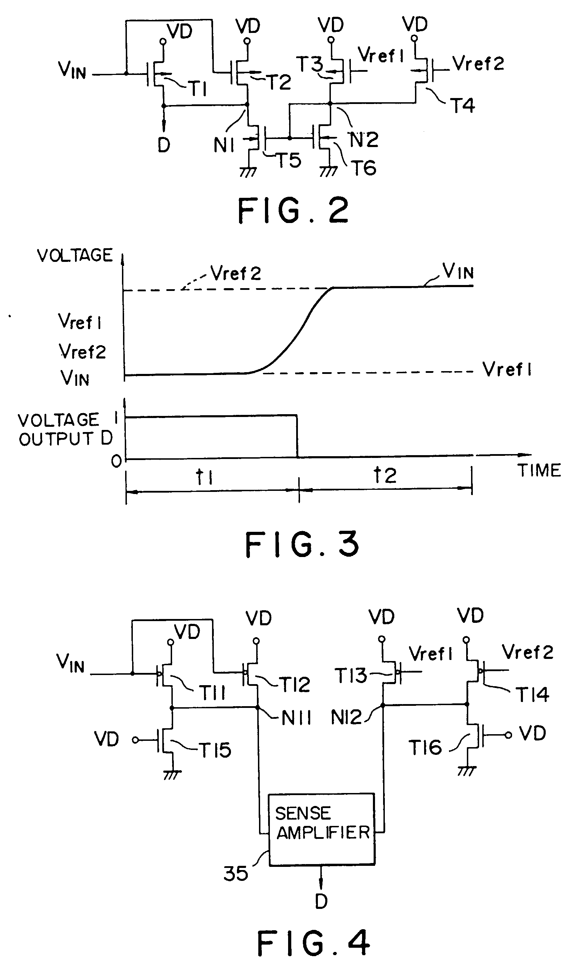

The data detection circuit 25 compares the potential V_{IN} which is output from the first load circuit 13 with the reference potentials V_{REF1} and V_{REF2} which are output from the second and third load circuits 14 and 24. The data detection circuit 25 is a difference sense amplifier circuit as shown in Fig. 2. P-channel transistors T1 and T2 have their sources connected to a power supply VD, drains connected in common, and gates applied with the potential V_{IN}. P-channel transistors T3 and T4 have their gates applied with potentials V_{REF1} and V_{REF2}, respectively, sources connected to the power supply VD, and drains connected in common to the gate and drain of an n-channel transistor T6. The source of transistor T6 is grounded and its gate is connected to the gate of another n-channel transistor T5. The drain of transistor T5 is connected to the drains of transistors T1 and T2. The source of transistor T5 is grounded. The comparison result by this circuit is output as a signal D from the node N1 of the drains of transistors T1 and T2.

The operation of the embodiment constructed as above will be described.

Memory cells connected to one of the row lines WL are selected by the row decoder 11, and one of the column gate transistors BT is turned on by the column decoder 12 to select one of the column lines. A data stored a memory cell at the intersection between the selected row and column is read. If the selected memory cell has no electrons injected in the floating gate, this memory cell is turned on so that the selected column line BL is discharged. On the other hand, if the selected memory cell has electrons injected in the floating gate, this memory cell is non-conductive so that the selected column line BL becomes charged.

The potential of the column line is applied to the data detection circuit 25 as the output potential V_{IN} from the first load circuit.

A read operation for the reference cell is executed in a similar manner. Two reference cells connected to the selected row line WL are selected. Upon selection of one of the reference cells DC11, DC21, ..., DCm1 in which no electrons are injected, this selected reference cell becomes conductive so that, similar to the memory cell which is not injected electrons, the reference column line DBL1 becomes discharged and the output voltage V_{REF1} is applied from the second load circuit 14 to the data detection circuit 25. On the other hand, upon selection of one of the reference cells DC12, DC22, ..., DCm2, no current path is formed in the selected reference cell so that the reference column line DBL2 becomes charged and the output voltage V_{REF2} is applied from the third load circuit 24 to the data detection circuit 25.

Next, the description will be given for the operation of the data detection circuit 25 which compares the output potential V_{IN} with the potential V_{REF1} and V_{REF2} and outputs a signal D. Fig. 3 is a timing chart illustrating the relationship between the potentials V_{IN}, V_{REF1} and V_{REF2}. As described previously, the potential V_{REF2} is higher than the potential V_{REF1}, and the potential V_{IN} is substantially the same as the potential V_{REF1} when a selected memory cell is not injected electrons in the floating gate (indicated at time duration tl), whereas the potential V_{IN} it is substantially the same as the potential V_{REF2} if a selected memory cell is injected electrons in the floating gate (indicated at time duration t2).

In the data detection circuit 25, the potential V_{REF1} output from the second load circuit 14 is applied to the gate of transistor T3, and the potential V_{REF2} from the third load circuit 15 is applied to the gate of transistor T4. The gates of transistors T1 and T2 are applied to the potential V_{IN} from the first load circuit 13.

The p-channel transistor T3 with the discharging state potential V_{REF1} being applied becomes conductive, whereas the p-channel transistor T4 with the charging state potential V_{REF2} being applied becomes non-conductive. Transistors T1 and T2 become conductive if the potential V_{IN} becomes in a discharging state as in the case of V_{REF1} (indicated at time duration t1), whereas they become non-conductive if the potential V_{IN} becomes in a charging state as in the case of V_{REF2} (indicated at time duration t2).

While the potential V_{IN} is in a discharging state (time duration t1), transistors T1 and T2 become conductive. The sum of the conductivity resistances of the conducted transistors T1 and T2 becomes smaller than the sum of the conductivity resistances of transistors T3 and T4. As a result, the data detection circuit 25 outputs a signal D of a logic "1" as shown in Fig. 3.

While the potential V_{IN} is in a charging state (time duration t2), both transistors T1 and T2 do not become conductive. The sum of the conductivity resistances of transistors T1 and T2 becomes larger than the sum of the conductivity resistances of transistors T3 and T4. As a result, the signal D of a logic "0" is outputted.

As described above, this embodiment provides two types of reference cells corresponding to two types of storage states of memory cells. The data stored in a memory cell and two reference cells are read by the three load circuits each having the same circuit arrangement. An output potential of the load circuit changes with the storage state of a selected memory cell, and it is compared with the two output potentials from the two reference cells of different type, to thereby detect the data stored in the selected memory cell.

As seen from the foregoing description, memory cells and reference cells are connected to the same row line, and the second and third load circuits 14 and 24 for reference cells as well as the first load circuit for memory cells have the same circuit arrangement. Accordingly, different from a conventional device, the current supply capability of the load transistor QD5 for reference cells can be set the same as that for memory cells. As a result, the influence of a power supply voltage fluctuation (power source noise) is the same for both memory cells and reference cells, thereby cancelling out the fluctuation and avoiding an erroneous operation.

For example, in the case where a memory cell which is not injected electrons is selected, the influence of a power source noise is the same for the output potential V_{IN} from the first load circuit 13, and for the output potential V_{REF1} from the second load circuit 14 connected to the reference cell which is not injected electrons. Although the output potential V_{REF2} from the third load circuit 24 also changes with the power source noise, the sum of the conductivity resistances of transistors T1 and T2 is maintained smaller than the sum of the conductivity resistances of transistors T3 and T4. Accordingly, even if there is a power source noise, the data detection circuit 25 outputs a signal D of "1".

Similarly, in the case where a memory cell which is injected electrons in the floating gate is selected, the influence of a power source noise is the same for the output potential V_{IN} from the first load circuit 13, and for the output potential V_{REF2} from the third load circuit 24. Although the output potential V_{REF1} from the second load circuit 14 also changes with the power source noise, the sum of the conductivity resistances of transistors T1 and T2 is maintained larger than the sum of the conductivity resistances of transistors T3 and T4. Accordingly, the data detection circuit 25 outputs a signal D of "0".

According to this embodiment, erroneous operation can be avoided even if a power supply voltage fluctuation occurs.

In the embodiment shown in Fi9. 2, the sizes of transistors T1, T2, T3, and T4 are made identical so that the sum of the conductivity resistances of transistors T1 and T2 while the potential V_{IN} is either in a charging state or in a discharging state, is made either larger or smaller than the sum of the conductivity resistances of transistors T3 and T4. The sizes of transistors T1, T2, T3 and T4 are not limited to be identical only if the above relationship is satisfied.

The above embodiment is not intended to limit the scope of this invention. For example, the load circuit may be realized with a different circuit arrangement only if it can output a signal in correspondence with the storage state of a memory cell or a reference cell. The data detecting circuit for detecting the storage state of a memory cell may be realized with a different circuit arrangement which is shown in Fig. 4 by way of example. Transistors T11, T12, T13 and T14 are n-channel MOSFETs of the same type having a threshold voltage of about 0 V and the same current supply capability. Similar to the data detection circuit shown in Fig. 2, the potential V_{IN} is applied to the gates of transistors T11 and T12, the reference potential V_{REF1} to the gate of transistor T13, and the reference potential V_{REF2} to the gate of transistor T14. The drains of transistors T11 to T14 are connected to a power source VD, and the sources of transistors T11 and T12 are connected in common to the drain of an n-channel enhancement transistor T15 at node N11. The gate of transistor T15 is connected to the power source VD and the source is grounded. The sources of transistors T13 and T14 are connected in common to the drain of an n-channel enhancement transistor T16 at node N12 The gate of transistor T16 is connected to the power source VD and the source is grounded. Transistors T15 and T16 have the same size. The sum of the conductivity resistances of transistors Tll and T12 becomes larger or smaller than the sum of the conduction resistances of transistors T13 and T14, in accordance with the storage state of a selected memory cell. This difference of potentials at nodes Nll and N12 is detected and amplified by a differential sense amplifier 35 and the result is output as a signal D. The above-described circuit may be used as the data detection circuit 25.

Although the reference column line DBL2 has no discharging path and is floated electrically in order for this floating state to not be used, a transistor T33 passing a small current may be connected between the reference column line DBL2 and ground as shown in Fig. 1A. In this case, transistors T31 and T32 passing a small current are also connected to the column lines BL and reference column line DBL1.

In order to pass the small current through the transistors T31, T32 and T33, a potential P which is slightly higher than the threshold voltages of the transistor T31, T32 and T33 is applied to the gates of the transistors T31, T32 and T33, respectively.

## Claims

1. A semiconductor memory device comprising:
at least one memory cell (MC11, ..., MCmn) for storing a binary data;
at least one first reference cell (DC11, ..., DCm1) for storing a first logic level of binary data;
a first load circuit (13) connected to said at least one memory cell (MC11, ..., MCmn);
a second load circuit (14,34) connected to said at least one first reference cell (DC11, ..., DCm1); and
a data detection circuit (15,25) for detecting the stored binary data of said at least one memory cell (MC11, MCmn) from received outputs of said first load circuit (13) and said second load circuit (14;34);
characterised in that:
at least one second reference cell (DC12, ..., DCm2) is provided for storing a second logic level of binary data which is opposite to said first logic level of binary data;
a third load circuit (24) is connected to said at least one second reference cell (DC12, ..., DCm2) ;
the resistances of the first, second and third load circuits (13;14, 34;24) being the same;
the data detection circuit comprises first and second input transistor circuits (T1/T2, T3/T4 or T11/T12, T13/T14);
the output (VIN) from the first load circuit (13) is applied to a gate terminal of the first input transistor circuit (T1/T2 or T11/T12);
the outputs from the second and third load circuits (14,24) are connected to respective gates of a pair of parallel-connected transistors (T3/T4 or T13/T14) of the second input transistor circuit; and
the data detection circuit is adapted to detect the stored binary data of said at least one memory cell based on the relative combined resistances of the first and second input transistor circuits.

2. The semiconductor memory device of claim 1, wherein each of said first, second and third load circuits (13;14, 34;24) has the same circuit configuration.

3. The semiconductor memory device of claim 2, wherein each of said first, second and third load circuits (13;14, 34;24) include first, second and third load transistors, respectively, having the same current supply capacity.

4. The semiconductor memory device according to any one of the preceding claims, wherein said at least one memory cell (MC11, ..., MCmn) has a floating gate, a logic state of the binary data stored in said at least one memory cell (MC11, MCmn) being determined by whether or not electrons are injected into said floating gate.

5. The semiconductor memory device according to claim 4, wherein said first logic level corresponds to a state in which electrons are not injected into said floating gate of said memory cell, and said second logic level corresponds to a state in which electrons are injected in said floating gate of said memory cell.

6. The semiconductor memory device according to any preceding claim, wherein said at least one memory cell (MC11, ..., MCmn), said at least one first reference cell (DC11, ..., DCm1) and said at least one second reference cell (DC12, DCm2) belong to a corresponding row and are connected to a common row line.

7. The semiconductor memory device according to any preceding claim wherein said data detection circuit (15,25) generates a first output when the output of said first load circuit (13) is equal to the output of said second load circuit (14,34) and generates a second output when the output of said first load circuit (13) is equal to the output of said third load circuit (24).

8. The semiconductor memory device according to any one of the preceding claims wherein said data detection circuit (15,25) comprises a differential sense amplifier.

9. The semiconductor memory device according to claim 8, wherein said first input transistor circuit comprises a pair of parallel-connected input transistors having respective gates connected to said gate terminal.

10. The semiconductor memory device according to claim 8 or 9, wherein said differential sense amplifier comprises:
first and second N channel transistors (T5,T6), gates thereof being commonly connected, and sources thereof being grounded,
said first input transistor circuit (T1,T2) comprising a P channel transistor, the output of said first load circuit (13) being applied to the gate thereof, a power supply voltage being applied to the source thereof and the drain thereof being connected to the drain of said first N channel transistor (T5),
said pair of input transistors of the second input circuit being P channel transistors, the outputs of said second (14,34) and third (24) load circuits being respectively applied to the gates thereof, the power supply voltage being applied to the sources thereof and the drains thereof being commonly connected to the drain and gate of said second N channel transistor (T6), and
detected data being obtained from the connection node (N1) between the drain of said first N channel transistor (T5) and the drain of said first input transistor (T1,T2).

11. The semiconductor memory device according to claim 8 or 9, wherein said differential sense amplifier comprises:
said first input transistor circuit (T11,T12) comprising an N channel transistor, the output of said first load circuit (13) being applied to the gate thereof, the drain thereof being applied to the power supply voltage, the sources thereof being connected to a first pull down transistor (T15), and said input transistors of the second input circuit being N channel transistors the output of said second (14,34) and third (24) load circuit being applied to the gates thereof, drains thereof being applied to the power supply voltage, sources thereof being commonly connected to a second pull down transistor (T16).

12. The semiconductor memory device according to any preceding claim, wherein leak means (T33) are provided for a second reference column line which connects said at least one second reference cell (DC12, ..., DCm2), said leak means (T33) prevents said second reference column line from an electrically floating state.

13. The semiconductor memory device according to any one of the preceding claims comprising:
a memory array having a plurality of memory cells (MC11, ..., MCmn) arranged in a matrix form which column line (BL1-BLn) and row line (WL1-WLn), each of said memory cells (-) storing a binary data;
a column decoder (12) to select one of said column lines (BL1-BLn);
a row decoder (11) to select one of said row lines (WL1-WLn);
a first reference column line (DBL1);
a second reference column line (DBL2);
a plurality of first reference cells (DC11; ..., DCm1) being connected to said first reference column line (DBL1),
a plurality of second reference cells (DC12, ..., DCm2) being connected to said second reference column line (DBL2),
said first load circuit (13) connected to said column lines (B21-BLn);
said second load circuit (14,34) connected to said first reference column line (DBL1); and
said third load circuit (24) connected to said second reference column line (DBL2).

14. A semiconductor memory device according to claim 13, wherein said first and second reference column lines (DBL1, DBL2) includes a first and second capacitance means (C1,C2) respectively, said first and second capacitance means (C1, C2) compensating a parasitic capacitance existing in said first and second reference column lines (DBL1, DBL2).

## Patentansprüche

1. Halbleiterspeichereinrichtung, umfassend:
wenigstens eine Speicherzelle (MC11, **...,** MCmn) zum Speichern eines binären Datenwerts;
wenigstens eine erste Referenzzelle (DC11, ..., DCm1) zum Speichern eines ersten Logikpegels von Binärdaten;
eine erste Lastschaltung (13), die mit der wenigstens einen Speicherzelle (MC11, ..., MCmn) verbunden ist;
eine zweite Lastschaltung (14, 34), die mit der wenigstens einen ersten Referenzzelle (DC11, ..., DCm1) verbunden ist; und
eine Datenerfassungsschaltung (15, 25) zum Erfassen der gespeicherten Binärdaten der wenigstens einen Speicherzelle (MC11, ..., MCmn) aus empfangenen Ausgängen der ersten Lastschaltung (13) und der zweiten Lastschaltung (14; 34);
dadurch gekennzeichnet, daß:
wenigstens eine zweite Referenzzelle (DC12, ..., DCm2) vorgesehen ist, zum Speichern eines zweiten Logikpegels von Binärdaten, der entgegengesetzt zu dem ersten Logikpegel von Binärdaten ist;
eine dritte Lastschaltung (24) mit der wenigstens einen zweiten Referenzzelle (DC12, ..., DCm2) verbunden ist;
die Widerstände der ersten, zweiten und dritten Lastschaltungen (13; 14, 34; 24) die gleichen sind;
die Datenerfassungsschaltung erste und zweite Eingangstransistorschaltungen (T1/T2, T3/T4 oder T11/T12, T13/T14) umfaßt;
der Ausgang (VIN) von der ersten Lastschaltung (13) an einen Gateanschluß der ersten Eingangstransistorschaltung (T1/T2 oder T11/T12) angelegt ist;
die Ausgänge von den zweiten und dritten Lastschaltungen (14, 24) mit jeweiligen Gates eines Paars von parallel geschalteten Transistoren (T3/T4 oder T13/T14) der zweiten Eingangstransistorschaltung verbunden sind; und
die Datenerfassungsschaltung ausgelegt ist, um den gespeicherten binären Datenwert der wenigstens einen Speicherzelle auf Grundlage der relativen kombinierten Widerstände der ersten und zweiten Eingangstransistorschaltungen zu erfassen.

2. Halbleiterspeichereinrichtung nach Anspruch 1, dadurch gekennzeichnet, daß jede der ersten, zweiten und dritten Lastschaltung (13; 14, 34; 24) die gleiche Schaltungskonfiguration aufweist.

3. Halbleiterspeichereinrichtung nach Anspruch 2, dadurch gekennzeichnet, daß jede der ersten, zweiten und dritten Lastschaltungen (13; 14, 34; 24) jeweils erste, zweite und dritte Lasttransistoren umfassen, die die gleiche Stromzuführungskapazität aufweisen.

4. Halbleiterspeichereinrichtung nach einem der vorangehenden Ansprüche, dadurch gekennzeichnet, daß die wenigstens eine Speicherzelle (MC11, ..., MCmn) ein Schwebungsgate aufweist, wobei ein Logikzustand des binären Datenwerts, der in der wenigstens einen Speicherzelle (MC11, ..., MCmn) gespeichert ist, dadurch bestimmt ist, ob oder ob nicht Elektronen in das Schwebungsgate injiziert sind.

5. Halbleiterspeichereinrichtung nach Anspruch 4, dadurch gekennzeichnet, daß der erste Logikpegel einem Zustand entspricht, in dem Elektronen nicht in das Schwebungsgate der Speicherzelle injiziert sind, und der zweite Logikpegel einem Zustand entspricht, in dem Elektronen in das Schwebungsgate der Speicherzelle injiziert sind.

6. Halbleiterspeichereinrichtung nach einem der vorangehenden Ansprüche, dadurch gekennzeichnet, daß die wenigstens eine Speicherzelle (MC11, ..., MCmn), die wenigstens eine erste Referenzzelle (DC11, ..., DCm1) und die wenigstens eine zweite Referenzzelle (DC12, ..., DCm2) zu einer entsprechenden Zeile gehören und mit einer gemeinsamen Zeilenleitung verbunden sind.

7. Halbleiterspeichereinrichtung nach einem der vorangehenden Ansprüche, dadurch gekennzeichnet, daß die Datenerfassungsschaltung (15, 25) einen ersten Ausgang erzeugt, wenn der Ausgang der ersten Lastschaltung (13) gleich zu dem Ausgang der zweiten Lastschaltung (14, 34) ist, und einen zweiten Ausgang erzeugt, wenn der Ausgang der ersten Lastschaltung (13) gleich zu dem Ausgang der dritten Lastschaltung (24) ist.

8. Halbleiterspeichereinrichtung nach einem der vorangehenden Ansprüche, dadurch gekennzeichnet, daß die Datenerfassungsschaltung (15, 25) einen Differenzerfassungsverstärker umfaßt.

9. Halbleiterspeichereinrichtung nach Anspruch 8, dadurch gekennzeichnet, daß die erste Eingangstransistorschaltung in Paar von parallel geschalteten Eingangstransistoren mit jeweiligen Gates umfaßt, die mit dem Gateanschluß verbunden sind.

10. Halbleiterspeichereinrichtung nach Anspruch 8 oder 9, dadurch gekennzeichnet, daß der Differenzerfassungsverstärker umfaßt:
erste und zweite N-Kanal-Transistoren (T5, T6), deren Gates zusammengeschaltet sind und deren Sourcen mit Masse verbunden sind,
wobei die erste Eingangstransistorschaltung (T1, T2) einen P-Kanal-Transistor umfaßt, der Ausgang der ersten Lastschaltung (13) an das Gate davon angelegt wird, eine Energieversorgungsspannung an die Source davon angelegt wird und die Drain davon mit der Drain des ersten N-Kanal-Transistors (T5) verbunden ist,
wobei das Paar von Eingangstransistoren der zweiten Eingangsschaltung P-Kanal-Transistoren sind, die Ausgänge der zweiten (14, 34) und dritten (24) Lastschaltungen jeweils an die Gates davon angelegt werden, die Energieversorgungsspannung an die Sourcen davon angelegt werden und die Drains davon gemeinsam mit der Drain und dem Gate des zweiten N-Kanal-Transistors (T6) verbunden sind, und
wobei erfaßte Daten von dem Verbindungsknoten (N1) zwischen der Drain des ersten N-Kanal-Transistors (T5) und der Drain des ersten Eingangstransistors (T1, T2) erhalten werden.

11. Halbleiterspeichereinrichtung nach Anspruch 8 oder 9, dadurch gekennzeichnet, daß der Differenzerfassungsverstärker umfaßt:
die erste Eingangstransistorschaltung (T11, T12), umfassend einen N-Kanal-Transistor, wobei der Ausgang der ersten Lastschaltung (13) an das Gate davon angelegt ist, die Drain davon an die Energieversorgungsspannung angelegt ist, die Sourcen davon mit einem ersten Herunterzieh-Transistor (T15) verbunden sind, und die Eingangstransistoren der zweiten Eingangsschaltung N-Kanal-Transistoren sind, der Ausgang der zweiten (14, 34) und dritten (24) Lastschaltung an die Gates davon angelegt sind, Drains davon an die Energieversorgungsspannung angelegt sind, und Sourcen davon gemeinsam mit einem zweiten Herunterzieh-Transistor (T16) verbunden sind.

12. Halbleiterspeichereinrichtung nach einem der vorangehenden Ansprüche, dadurch gekennzeichnet, daß eine Leckeinrichtung (T33) für eine zweite Referenzspaltenleitung vorgesehen ist, die die wenigstens eine zweite Referenzzelle (DC12, ..., DCm2) verbindet, wobei die Leckeinrichtung (T33) die zweite Referenzspaltenleitung von einem elektrisch schwebenden Zustand abhält.

13. Halbleiterspeichereinrichtung nach einem der vorangehenden Ansprüche, umfassend:
ein Speicherfeld mit einer Vielzahl von Speicherzellen (MC11, ..., MCmn), die in einer Matrixform mit einer Spaltenleitung (BL1-BLn) und einer Zeilenleitung (WL1-WLn) angeordnet sind, wobei jede der Speicherzellen (-) einen binären Datenwert speichert;
einen Spaltendecoder (12) zum Wählen einer der Spaltenleitungen (BL1-BLn);
einen Zeilendecoder (11) zum Wählen einer der Zeilenleitungen (WL1-WLn);
eine erste Referenzspaltenleitung (DBL1);
eine zweite Referenzspaltenleitung (DBL2);
eine Vielzahl von ersten Referenzzellen (DC11, ..., DCm1), die mit der ersten Referenzspaltenleitung (DBL1) verbunden sind;
eine Vielzahl von zweiten Referenzzellen (DC12, ..., DCm2), die mit der zweiten Referenzspaltenleitung (DBL2) verbunden sind;
die erste Lastschaltung (13), die mit den Spaltenleitungen (B21-BLn) verbunden ist;
die zweite Lastschaltung (14, 34), die mit der ersten Referenzspaltenleitung (DBL1) verbunden ist; und
die dritte Lastschaltung (24), die mit der zweiten Referenzspaltenleitung (DBL2) verbunden ist.

14. Halbleiterspeichereinrichtung nach Anspruch 13, dadurch gekennzeichnet, daß die ersten und zweiten Referenzspaltenleitungen (DBL1, DBL2) jeweils eine erste und zweite Kapazitätseinrichtung (C1, C2) umfassen, wobei die ersten und zweiten Kapazitätseinrichtungen (C1, C2) eine parasitäre Kapazität kompensieren, die in den ersten und zweiten Referenzspaltenleitungen (DBL1, DBL2) existiert.

## Revendications

1. Dispositif de mémoire à semi-conducteur comprenant:
au moins une cellule de mémoire (MC11, ..., MCmn), pour stocker une donnée binaire;
au moins une première cellule de référence (DC11, ..., DCm1), pour stocker un premier niveau logique de données binaires;
un premier circuit de charge (13), connecté à ladite au moins une cellule de mémoire (MC11, ..., MCmn);
un deuxième circuit de charge (14, 34) connecté à ladite au moins une première cellule de référence (DC11, ..., DCm1); et
un circuit de détection de données (15, 25), pour détecter les données binaires stockées de ladite au moins une cellule de mémoire (MC11, ..., MCmn), provenant de sorties reçues dudit premier circuit de charge (13) et dudit deuxième circuit de charge (14, 34);
caractérisé en ce que:
au moins une deuxième cellule de référence (DC12 , ..., DCm2) est fournie pour stocker un deuxième niveau logique de données binaires, qui est opposé audit premier niveau logique de données binaires;
un troisième circuit de charge (24) est connecté à ladite au moins une deuxième cellule de référence (DC12, ..., DCm2) ;
les résistances des premier, deuxième et troisième circuits de charge (13;14, 34;24) étant les mêmes;
le circuit de détection de données comprend un premier et un deuxième circuits d'entrée à transistors (T1/T2, T3/T4 ou T11/T12, T13/T14) ;
la sortie (VIN) du premier circuit de charge (13) est appliquée à une borne de grille du premier circuit d'entrée à transistors (T1/T2 ou T11/T12) ;
les sorties du deuxième et du troisième circuits de charge (14, 24) sont connectées aux grilles respectives d'une paire de transistors connectés en parallèle (T3/T4 ou T13/T14) du deuxième circuit d'entrée à transistors; et
le circuit de détection de données est susceptible de détecter les données binaires stockées de ladite au moins une cellule de mémoire, sur la base des résistances relatives associées du premier et du deuxième circuits d'entrée à transistors.

2. Dispositif de mémoire à semi-conducteur selon la revendication 1, dans lequel chacun desdits premier, deuxième et troisième circuits de charge (13;14, 34;24) a la même configuration.

3. Dispositif de mémoire à semi-conducteur selon la revendication 2, dans lequel chacun desdits premier, deuxième et troisième circuits de charge (13;14, 34;24) comporte respectivement un premier, deuxième et troisième transistors de charge, ayant la même capacité en fourniture de courant.

4. Dispositif de mémoire à semi-conducteur selon l'une quelconque des revendications précédentes, dans lequel ladite au moins une cellule de mémoire (MC11, ..., MCmn) a une grille flottante, un état logique des données binaires stockées dans ladite au moins une cellule de mémoire (MC11, ..., MCmn) étant déterminé par le fait que des électrons sont injectés ou non dans ladite grille flottante.

5. Dispositif de mémoire à semi-conducteur selon la revendication 4, dans lequel ledit premier niveau logique correspond à un état dans lequel des électrons ne sont pas injectés dans ladite grille flottante de ladite cellule de mémoire, et ledit deuxième niveau logique correspond à un état dans lequel des électrons sont injectés dans ladite grille flottante de ladite cellule de mémoire.

6. Dispositif de mémoire à semi-conducteur selon l'une quelconque des revendications précédentes, dans lequel ladite au moins une cellule de mémoire (MC11, ..., MCmn), ladite au moins une première cellule de référence (DC11, ..., DCm1) et ladite au moins une deuxième cellule de référence (DC12, ..., DCm2), appartiennent à une rangée correspondante, et sont connectées à une ligne de rangées commune.

7. Dispositif de mémoire à semi-conducteur selon l'une quelconque des revendications précédentes, dans lequel ledit circuit de détection de données (15, 25) génère une première sortie lorsque la sortie dudit premier circuit de charge (13) est égale à la sortie dudit deuxième circuit de charge (14, 34), et génère une deuxième sortie lorsque la sortie dudit premier circuit de charge (13) est égale à la sortie dudit troisième circuit de charge (24).

8. Dispositif de mémoire à semi-conducteur selon l'une quelconque des revendications précédentes, dans lequel ledit circuit de détection de données (15, 25) comprend un amplificateur différentiel de lecture.

9. Dispositif de mémoire à semi-conducteur selon la revendication 8, dans lequel ledit premier circuit d'entrée à transistors comprend une paire de transistors d'entrée connectés en parallèle, ayant des grilles respectives connectées à ladite borne de grille.

10. Dispositif de mémoire à semi-conducteur selon la revendication 8 ou 9, dans lequel ledit amplificateur différentiel de lecture comprend:
un premier et un deuxième transistors à canal N (T5, T6), dont les grilles sont connectées en commun, et dont les sources sont reliées à la masse,
ledit premier circuit de transistor d'entrée (T1, T2) comprenant un transistor à canal P, la sortie dudit premier circuit de charge (13) étant appliquée à la grille de celui-ci, une tension d'alimentation étant appliquée à la source de celui-ci et le drain de celui-ci étant connecté au drain dudit premier transistor à canal N (T5),
ladite paire de transistors d'entrée du deuxième circuit d'entrée étant constituée de transistors à canal P, les sorties desdits deuxième (14, 34) et troisième (24) circuits de charge étant appliqués respectivement aux grilles de ceux-ci, la tension d'alimentation étant appliquée aux sources de ceux-ci et les drains de ceux-ci étant connectés en commun au drain et à la grille dudit deuxième transistor à canal N (T6), et
les données détectées étant obtenues depuis le noeud de connexion (N1) situé entre le drain dudit premier transistor à canal N (T5) et le drain dudit premier transistor d'entrée (T1, T2).

11. Dispositif de mémoire à semi-conducteur selon la revendication 8 ou 9, dans lequel ledit amplificateur différentiel de lecture comprend:
ledit premier circuit d'entrée à transistors (T11, T12) comprenant un transistor à canal N, la sortie dudit premier circuit de charge (13) étant appliquée à la grille de celui-ci, le drain de celui-ci étant appliqué à la tension d'alimentation, la source de celui-ci étant appliquée à un premier transistor de tirage vers le bas (T15) et lesdits transistors d'entrée du deuxième circuit d'entrée étant des transistors à canal N, la sortie desdits deuxième (14, 34) et troisième (24) circuits de charge étant appliquée aux grilles de ceux-ci, les drains de ceux-ci étant appliqués à la tension d'alimentation, les sources de ceux-ci étant connectées en commun à un deuxième transistor de tirage vers le bas (T16).

12. Dispositif de mémoire à semi-conducteur selon l'une quelconque des revendications précédentes, dans lequel des moyens de fuite (T33) sont fournis pour une deuxième ligne de colonnes de référence, qui connecte ladite au moins une deuxième cellule de référence (DC12, ..., DCm2), lesdits moyens de fuite (T33) empêchent ladite deuxième ligne de colonnes de référence de se trouver dans un état électriquement flottant.

13. Dispositif de mémoire à semi-conducteur selon l'une quelconque des revendications précédentes, comprenant:
un réseau de mémoire ayant une pluralité de cellules de mémoire (MC11, ..., MCmn), agencées sous forme de matrice avec une ligne de colonnes (BL1-BLn) et une ligne de rangées (WL1-WLn), chacune desdites cellules de mémoire (-) contenant une donnée binaire;
un décodeur de colonne (12) pour sélectionner l'une desdites lignes de colonnes (BL1-BLn);
un décodeur de rangées (11) pour sélectionner l'une desdites lignes de rangées (WL1-WLn);
une première ligne de colonnes de référence (DBL1) ;
une deuxième ligne de colonnes de référence (DBL2) ;
une pluralité de premières cellules de référence (DC11, ..., DCm1), connectées à ladite première ligne de colonnes de référence (DBL1),
une pluralité de deuxièmes cellules de référence (DC12, ..., DCm2), connectées à ladite deuxième ligne de colonnes de référence (DBL2),
ledit premier circuit de charge (13) connecté auxdites lignes de colonnes (B21-BLn);
ledit deuxième circuit de charge (14, 34) connecté à ladite première ligne de colonnes de référence (DBL1);
ledit troisième circuit de charge (24) connecté à ladite deuxième ligne de colonnes de référence (DBL2).

14. Dispositif de mémoire à semi-conducteur selon la revendication 13, dans lequel lesdites première et deuxième lignes de colonnes de référence (DBL1, DBL2) comportent respectivement des premiers et deuxièmes moyens de capacité (C1, C2), lesdits premiers et deuxièmes moyens de capacité (C1, C2) compensant une capacité parasite existant dans lesdites première et deuxième lignes de colonnes de référence (DBL1, DBL2).
